(19) Europäisches Patentamt
European Patent Office
Office européen des brevets

(11) **EP 2 400 572 A1**

## (12) EUROPEAN PATENT APPLICATION
published in accordance with Art. 153(4) EPC

(43) Date of publication:
**28.12.2011 Bulletin 2011/52**

(21) Application number: **07860274.5**

(22) Date of filing: **19.12.2007**

(51) Int Cl.:
*H01L 35/20* (2006.01)    *C02F 11/00* (2006.01)
*C02F 11/12* (2006.01)    *C04B 35/00* (2006.01)
*C04B 35/58* (2006.01)    *H01L 35/34* (2006.01)

(86) International application number:
**PCT/JP2007/075052**

(87) International publication number:
**WO 2008/075789 (26.06.2008 Gazette 2008/26)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **20.12.2006 JP 2006342656**

(71) Applicants:
• **Showa KDE Co., Ltd.**
  **Tokyo 171-0021 (JP)**
• **Tokyo University Of Science**
  **Educational Foundation Administrative Organization**
  **Shinjuku-ku**
  **Tokyo 162-8601 (JP)**

• **Nippon Thermostat Co., Ltd.**
  **Kiyose-shi**
  **Tokyo 204-0003 (JP)**

(72) Inventors:
• **IIDA, Tsutomu**
  **Tokyo 162-8601 (JP)**
• **MITO, Yohiko**
  **Toshima-ku, Tokyo 1710021 (JP)**
• **NEMOTO, Takashi**
  **Kiyose-shi**
  **Tokyo 204-0003 (JP)**

(74) Representative: **Mommer, Niels**
  **Twelmeier Mommer & Partner**
  **Westliche Karl-Friedrich-Strasse 56-68**
  **75172 Pforzheim (DE)**

(54) **THERMO-ELECTRIC CONVERTING MATERIALS, PROCESS FOR PRODUCING THE SAME, AND THERMO-ELECTRIC CONVERTING ELEMENT**

(57)    A thermoelectric conversion material is provided which stably exhibits high thermoelectric conversion performance at about 300 to 600°C and has high physical strength, resistance to weathering, durability, stability, and reliability. A method for manufacturing the same, and a thermoelectric conversion element are also provided. Also provided is a thermoelectric conversion material produced using, as a raw material, silicon sludge which has had to be disposed of in landfill. The thermoelectric conversion material of the invention is **characterized by** containing, as a main component, a sintered body composed of polycrystalline magnesium silicide containing at least one element selected from As, Sb, P, Al, and B. The manufacturing method uses purified and refined silicon sludge.

FIG. 2

EP 2 400 572 A1

Printed by Jouve, 75001 PARIS (FR)

**Description**

TECHNICAL FIELD

The present invention relates to a thermoelectric conversion material, to a method for manufacturing the same, and to a thermoelectric conversion element.

BACKGROUND ART

Waste silicon sludge is produced when silicon ingots and wafers composed of high-purity silicon used to manufacture silicon products such as semiconductors and solar cells are ground and polished. Such silicon sludge has a very small particle size of 0.1 to 10 $\mu$m and contains, in addition to silicon, boron, phosphorus, tungsten, chromium, titanium, arsenic, gallium, iron, oxygen, and other materials that have been implanted as impurities into the surface of the wafers by ion implantation. The silicon sludge further contains polyaluminum chloride and aluminum sulfate that are used as flocculants added to flocculate and precipitate the silicon sludge.

Moreover, water is used to improve the lubricity during grinding and polishing. However, since oil and other materials are added to the water, the silicon sludge contains various impurities including oil.

As described above, since silicon sludge contains various metal elements and organic and inorganic substances, in addition to silicon, there has been no choice but to treat the silicon sludge as so-called waste sludge and dispose of it in landfill.

Moreover, a large amount of produced silicon sludge to be disposed of in landfill must be rendered harmless before landfill disposal under the regulation of landfill sites. Another problem is that the number of available landfill sites is decreasing in recent years.

Such very fine grain silicon sludge containing various impurities in addition to silicon requires a large amount of time and cost for treatment.

As described above, conventional silicon sludge contains a flocculant and oil. However, a method has been proposed in which silicon sludge and water are efficiently separated through a filter without using a flocculant and oil to obtain silicon sludge separated by filtration so as to have a silicon concentration of 90 mass % or more and a water content of 90 mass % or less (see, for example, Patent Document 1).

Moreover, many other methods and apparatuses have been proposed (see, for example, Patent Documents 2 to 4). In one method, cations are caused to dissolve in polluted liquid to flocculate the suspended particles in the liquid. In other methods and apparatuses, a material generating cations (such as magnesium, magnesium sulfate, magnesium oxide, magnesium hydroxide, magnesium carbonate, calcium oxide, calcium hydroxide, calcium carbonate, aluminum, aluminum oxide, or aluminum hydroxide) is placed in a vessel, and polluted liquid passing through the vessel is brought into contact with the placed material, thereby causing cations to dissolve in the polluted liquid to flocculate the suspended particles in the liquid.

Meanwhile, MgSiA serving as a thermoelectric material (A is a dopant element such as P, As, or Sb) in which part of Si particles are dispersed in a non-coagulated state has been proposed (see, for example, Patent Document 6).

In this proposal, the Si particles are dispersed in a non-coagulate state, and therefore a thermoelectric conversion material with stable performance may be difficult to obtain.

Recently, with increasing awareness of environmental problems, various means for effectively utilizing various types of energy are being studied.

Particularly, with the increase in the amount of industrial waste, effective utilization of the waste heat generated during the incineration of the waste has become an important task. For example, in large-scale waste incineration facilities, waste heat is recovered by operating boilers with the waste heat to generate electricity by steam turbines. However, in medium- and small-scale waste incineration facilities, which are a large majority of waste incineration facilities, electricity generation using a turbine cannot be used because of its high dependency on scale merit.

Accordingly, to generate electricity by utilizing such waste heat, thermoelectric conversion elements have been proposed which use thermoelectric conversion materials capable of reversible thermoelectric conversion using the Seebeck or Peltier effect, which has no dependency on scale merit.

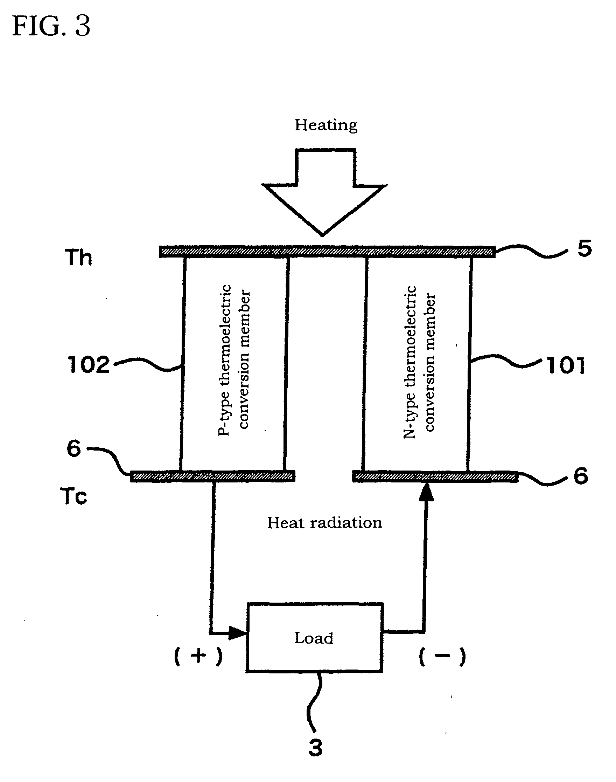

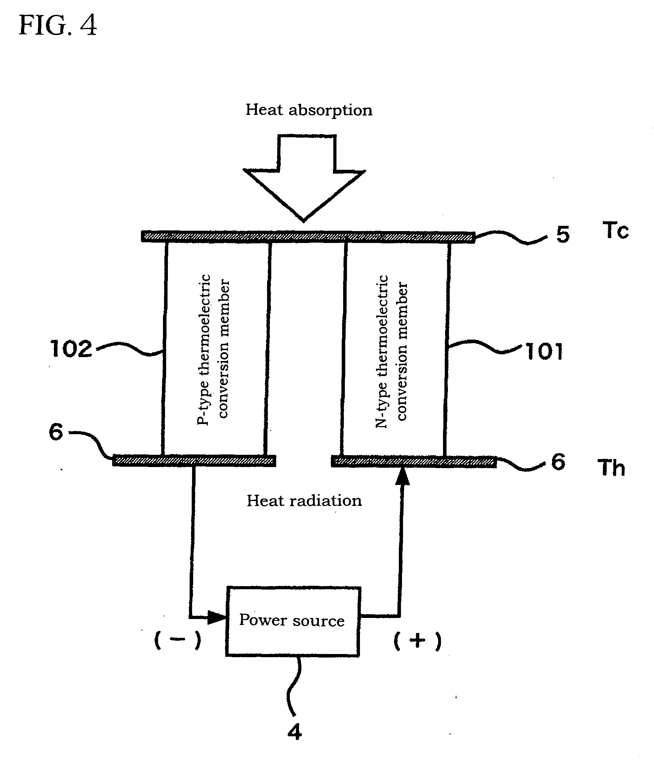

For example, in one thermoelectric conversion element, n- and p-type semiconductors having a low thermal conductivity are used as thermoelectric conversion materials for n- and p-type thermoelectric conversion members. As shown in Figs. 3 and 4, electrodes 5 and 6 are disposed on the upper and lower ends of the n-type thermoelectric conversion member 101 and the p-type thermoelectric conversion member 102 arranged in parallel to each other. The electrodes 5 on the upper ends of the thermoelectric conversion members 101 and 102 are connected and integrated together, and the electrodes 6 on the lower ends of the thermoelectric conversion members 101 and 102 are separated from each other.

An electromotive force can be generated between the electrodes 5 and 6 by creating a temperature difference therebetween.

Conversely, when a direct current is applied between the electrodes 6 on the lower ends of the thermoelectric conversion members 101 and 102, heat generation and absorption occur at the electrodes 5 and 6.

In another example of the thermoelectric conversion element, only an n-type semiconductor having a low thermal conductivity is used as the thermoelectric conversion material, and electrodes 5 and 6 are disposed on the upper and lower ends of an n-type thermoelectric conversion member 103, as shown in Figs. 5 and 6 (see Patent Document 5).

An electromotive force can be generated between the electrodes 5 and 6 by creating a temperature difference therebetween.

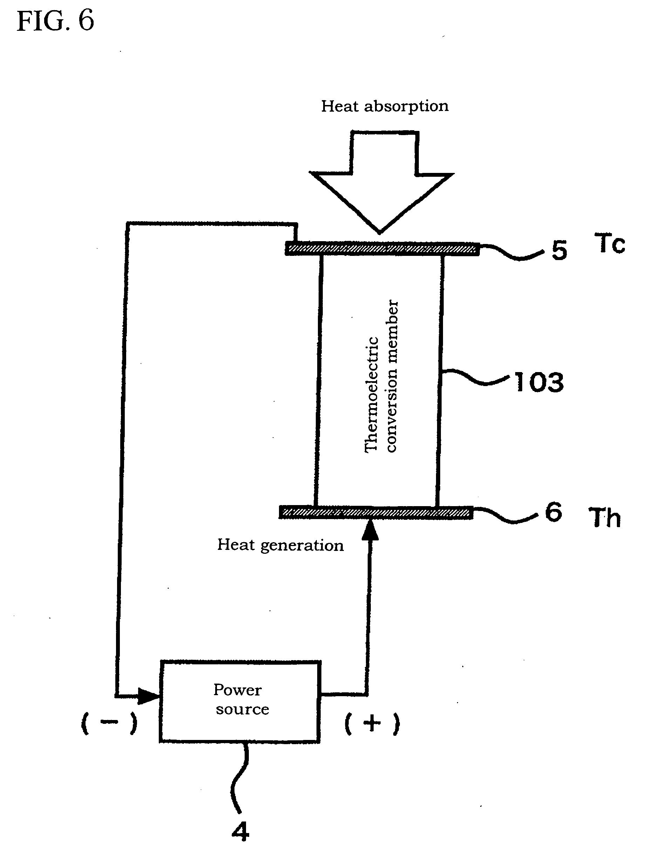

Conversely, when a direct current is applied between the electrodes 5 and 6 of the n-type thermoelectric conversion member 103, as shown in Fig. 6, heat generation and absorption occur at the electrodes 5 and 6.

Specifically, with reference to Fig. 3, when heat is applied to the electrode 5 side or is allowed to dissipate from the electrode 6 side, a positive temperature difference (Th - Tc) is created between the electrodes 5 and 6, and the potential becomes greater in the p-type thermoelectric conversion member 102 than in the n-type thermoelectric conversion member 101 because of thermally excited carriers. Therefore, when a resistance 3 serving as a load is connected between the left and right electrodes 6, a current flows from the p-type thermoelectric conversion member 102 to the n-type thermoelectric conversion member 101 side.

On the other hand, as shown in Fig. 4, when a direct current is applied from a DC power supply 4 so as to flow from the p-type thermoelectric conversion member 102 to the n-type thermoelectric conversion member 101, heat absorption and heat generation occur at the electrodes 5 and 6, respectively.

Conversely, when a direct current is applied so as to flow from the n-type thermoelectric conversion member 101 to the p-type thermoelectric conversion member 102, heat generation and heat absorption occur at the electrodes 5 and 6, respectively.

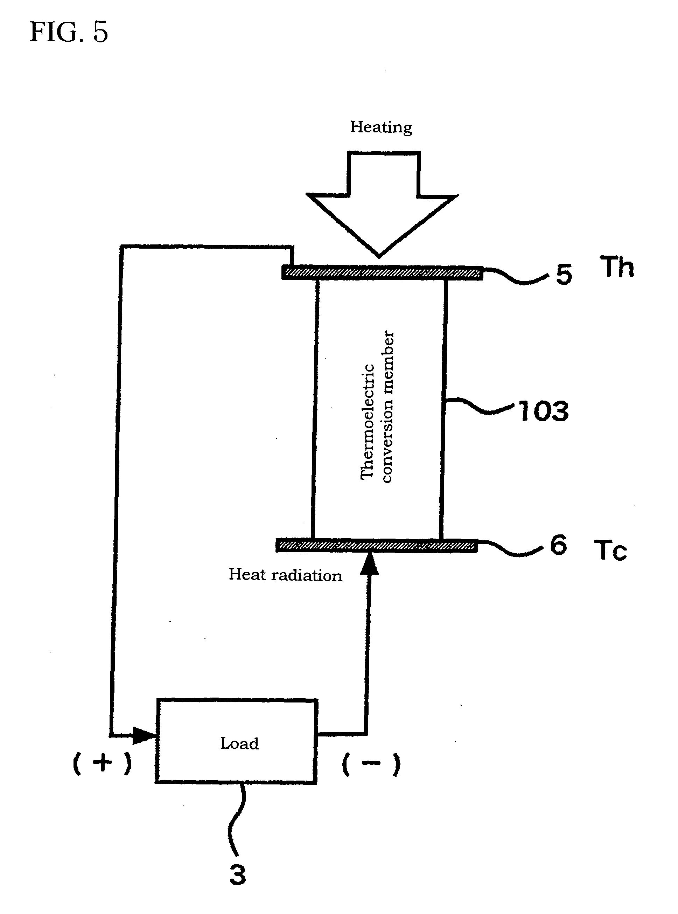

With reference to Fig. 5, when heat is applied to the electrode 5 side or is allowed to dissipate from the electrode 6 side, a positive temperature difference (Th - Tc) is created between the electrodes 5 and 6, and the potential becomes greater on the electrode 5 side than on the electrode 6 side. When a resistance 3 serving as a load is connected between the electrodes 5 and 6, a current flows from the electrode 5 side to the electrode 6 side.

On the other hand, as shown in Fig. 6, when a direct current is applied from a DC power supply 4 so as to flow from the electrode 6 to the electrode 5 through the n-type thermoelectric conversion member 103, heat absorption and heat generation occur at the electrodes 5 and 6, respectively.

Conversely, when a direct current is applied from the DC power supply 4 so as to flow from the electrode 5 to the electrode 6 through the n-type thermoelectric conversion member 103, heat generation and heat absorption occur at the electrodes 5 and 6, respectively.

The above thermoelectric conversion elements having very simple structures are capable of efficient thermoelectric conversion and are conventionally used mainly in special applications.

The thermoelectric conversion performance of such thermoelectric conversion members is generally evaluated using a performance index Z (unit: $K^{-1}$) represented by the following equation (1):

$$Z = \alpha^2 / (\kappa\rho). \qquad (1)$$

In equation (1), $\alpha$, $\kappa$, and $\rho$ are the Seebeck coefficient (thermoelectromotive force), thermal conductivity, and specific resistance, respectively.

A non-dimensional performance index ZT non-dimensionalized by multiplying the performance index Z by temperature T is used as a measure of practicality. For the purpose of practical use, the value of ZT is, for example, 0.5 or more and preferably 1 or more.

Specifically, to obtain good thermoelectric conversion performance, a material having a high Seebeck coefficient $\alpha$, low thermal conductivity $\kappa$, and low specific resistance $\rho$ is selected.

Accordingly, Bi-Te-based, Co-Sb-based, Zn-Sb-based, Pb-Te-based, Ag-Sb-Ge-Te-based, and other thermoelectric conversion materials have been conventionally used to attempt to generate electricity by utilizing waste heat sources of about 200°C to about 800°C, such as fuel cells, motor vehicles, boilers, incinerators, and blast furnaces. However, the problem of such materials is that hazardous substances contained therein increase the environmental load.

Boron-rich borides such as $B_4C$, chalcogenides of rare earth metals such as LaS, and other materials are under investigation for high temperature use. Such non-oxide-based materials, such as $B_4C$ and LaS, composed mainly of intermetallic compounds exhibit relatively high performance in a vacuum. However, the problem of these materials is that their crystalline phases are decomposed at high temperatures, so that the stability in the high temperature region is poor.

Moreover, silicide-based materials with less environmental load, such as $Mg_2Si$ (see, for example, Non-Patent documents 1 to 3), $Mg_2Si_{1-X}C_X$ (see, for example, Non-Patent document 4), and $MnSi_{1.75}$, are under investigation. However, these materials are difficult to manufacture because, for example, high chemical reactivity of Mg poses danger. In addition, there are several problems in that the manufactured materials are not usable because they are brittle and therefore weathered and that the thermoelectric conversion performance is low.

Patent Document 1: Japanese Patent No. 3291487.
Patent Document 2: Japanese Patent Application Laid-Open No. 2003-200005.
Patent Document 3: Japanese Patent Application Laid-Open No. 2003-103267.
Patent Document 4: Japanese Patent Application Laid-Open No. 2004-122093.
Patent Document 5: Japanese Patent Application Laid-Open No. H11-274578.
Patent Document 6: Japanese Patent Application Laid-Open No. 2002-285274.
Non-Patent Document 1: Semiconducting Properties of Mg2Si Single Crystals, Physical Review Vol.109, No.6, March 15, 1958, P. 1909-1915.
Non-Patent Document 2: Seebeck Effect In Mg2Si Single Crystals, J. Phys. Chem. Solids, Pergamon Press 1962, Vol.23, pp. 601-610.
Non-Patent Document 3: Bulk crystal growth of Mg2Si by the vertical Bridgman method, Science Direct, Thin Solid Films, 461 (2004) 86-89.
Non-Patent Document 4: Thermoelectric properties of $Mg_2Si$ crystal grown by the Bridgman method.

DISCLOSURE OF THE INVENTION

A first object of the invention is to provide a thermoelectric conversion material that stably exhibits high thermoelectric conversion performance at about 300 to 600°C and has high physical strength, resistance to weathering, durability, stability, and reliability, to provide a method for manufacturing the same, and to provide a thermoelectric conversion element.

A second object of the invention is to provide a method for manufacturing the above thermoelectric conversion material using, as a raw material, silicon sludge that has had to be disposed of in landfill.

The present inventors have conducted extensive studies and found that a sintered body composed mainly of magnesium silicide ($Mg_2Si$) containing at least one element selected from As, Sb, P, Al, and B is a good thermoelectric conversion material exhibiting desired performance. Thus, the first object can be achieved by such a sintered body. The inventors have also found that the second obj ect can be achieved by a special manufacturing method including a series of steps including a step of purifying and refining silicon sludge. Thus, the invention described below has been completed.

Specifically, the above objects are achieved by the invention described below.

A first aspect of the invention is (1) "a thermoelectric conversion material including a sintered body composed of, as a main component, polycrystalline magnesium silicide ($Mg_2Si$) containing at least one element selected from As, Sb, P, Al, and B."

A second aspect of the invention is (2) "the thermoelectric conversion material of the second aspect, wherein a silicon component of the magnesium silicide is made from silicon sludge as a raw material."

A third aspect of the invention is (3) "the thermoelectric conversion material of the first or second aspect, wherein each of amounts of As and Sb is 1 to 1000 ppm, each of amounts of P and B is 0.1 to 100 ppm, and an amount of Al is 10 to 10000 ppm."

A fourth aspect of the invention is (4) "the thermoelectric conversion material of any of the first to third aspects, containing As and Bi."

A fifth aspect of the invention is (5) "the thermoelectric conversion material of any of the first to fourth aspects, wherein a density of the sintered body is 70% or more of a theoretical value, and a non-dimensionalized performance factor ZT at an operating temperature of 300 to 600°C is 0.5 or more."

A sixth aspect of the invention is (6) "the thermoelectric conversion material of any of the first to fifth aspects, wherein particles of the magnesium silicide constituting the sintered body are in contact with each other, and at least part of the particles are in a fusion bonded state."

A seventh aspect of the invention is (7) "a thermoelectric conversion element including: two electrodes; and a thermoelectric conversion member disposed between the two electrodes and composed of, as a constituent component, a thermoelectric conversion material of any of the first to sixth aspects."

The above obj ects are also achieved by the invention described below.

An eighth aspect of the invention is (8) "a method for manufacturing a thermoelectric conversion material, including: a mixing step of mixing silicon and magnesium to obtain a mixture; a synthesizing step of synthesizing magnesium silicide by melting the obtained mixture in a sealed condition under a reducing atmosphere; and a sintering step of pressurizing-compression-sintering the synthesized magnesium silicide, these steps being sequentially performed, wherein high-purity silicon and/or purified and refined silicon is used as the silicon, and wherein, in the mixing step, the synthesizing step, and/or the firing step, at least one element selected from As, Sb, P, Al, and B is added as a dopant if necessary."

A ninth aspect of the invention is (9) "the method of the eighth aspect for manufacturing a thermoelectric conversion material, further including, after the synthesizing step and before the sintering step, a pulverizing step of pulverizing the magnesium silicide."

A tenth aspect of the invention is (10) "the method of the eighth or ninth aspect for manufacturing a thermoelectric conversion material, further including a silicon oxide eliminating step, and wherein the purified and refined silicon is obtained by subjecting silicon sludge to the silicon oxide eliminating step."

An eleventh aspect of the invention is (11) "the method of the tenth aspect for manufacturing a thermoelectric conversion material, wherein the silicon oxide eliminating step is performed at 400 to 1000°C under reduced pressure in a reducing atmosphere containing hydrogen gas and/or deuterium gas and, if necessary, an inert gas."

A twelfth aspect of the invention is (12) "the method of the tenth or eleventh aspect for manufacturing a thermoelectric conversion material, further including the dewatering step, and wherein the purified and refined silicon is obtained by performing the dewatering step before the silicon oxide eliminating step, the dewatering step being performed at 80 to 500°C in air, vacuum, or a gas atmosphere."

A thirteenth aspect of the invention is (13) "the method of any of the tenth to twel f th aspects for manufacturing a thermoelectric conversion material, wherein, before the dewatering step in the purifying and refining step, the silicon sludge is subjected to filtration and separation treatment so as to have a silicon concentration of 90 mass % or more and a water content of 10 mass % or less."

A fourteenth aspect of the invention is (14) "the method of any of the eighth to thirteenth aspects for manufacturing a thermoelectric conversion material, wherein before the synthesizing step the mixture obtained in the mixing step is dewatered at 80 to 500°C under reduced pressure."

A fifteenth aspect of the invention is (15) "the method of any of the eighth to fourteenth aspects for manufacturing a thermoelectric conversion material, wherein, in the synthesizing step, the magnesium silicide is generated by heat-treating and melting the magnesium and the silicon at a temperature between the melting point of magnesium and the melting point of silicon under reduced pressure in a reducing atmosphere containing hydrogen gas and, if necessary, an inert gas."

A sixteenth aspect of the invention is (16) "the method of any of the eighth to fifteenth aspects for manufacturing a thermoelectric conversion material, wherein in the synthesizing step the mixture obtained in the mixing step is melted in a crucible made of a material containing Al."

A seventeenth aspect of the invention is (17) "the method of any of the eighth to sixteenth aspects for manufacturing a thermoelectric conversion material, wherein in the sintering step the $Mg_2Si$ powder obtained by pulverization is sintered at a sintering temperature of 600 to 1000°C and a sintering pressure of 5 to 60 MPa under reduced pressure using a pressurizing compression sintering method."

An eighteenth aspect of the invention is (18) "the method of any of the eighth to seventeenth aspects for manufacturing a thermoelectric conversion material, wherein purified and refined silicon or high-purity silicon is used as the silicon, and the silicon and the magnesium are mixed in an atomic ratio of mg : Si being 2.2 : 0.8 to 1.8 : 1.2."

A nineteenth aspect of the invention is (19) "the method of any of the eighth to seventeenth aspects for manufacturing a thermoelectric conversion material, wherein a mixture of purified and refined silicon and high-purity silicon is used as the silicon, wherein the purified and refined silicon is mixed with the high-purity silicon such that a ratio of the high-purity silicon to the purified and refined silicon is 0 to 50 mass % / 100 to 0 mass %, and wherein the magnesium is mixed with the mixture of the purified and refined silicon and the high-purity silicon in an atomic ratio of Mg : Si being 2.2 : 0.8 to 1.8 : 1.2."

A twentieth aspect of the invention is (20) "the method of any of the eighth to nineteenth aspects for manufacturing a thermoelectric conversion material, wherein the silicon sludge is a waste product produced during grinding and/or polishing of a silicon ingot and/or a silicon wafer."

A twenty first aspect of the invention is (21) "the method of any of the eighth to twentieth aspects for manufacturing a thermoelectric conversion material, wherein p-type silicon sludge containing B is used as the silicon sludge."

A twenty second aspect of the invention is (22) "the method of any of the eighth to twenty first aspects for manufacturing a thermoelectric conversion material, wherein n-type silicon sludge containing at least one of As, Sb, and P is used as the silicon sludge."

A twenty third aspect of the invention is (23) purified and refined silicon obtained by subjecting silicon sludge at least to a silicon oxide eliminating step, the purified and refined silicon containing no silicon oxide and being packed in a container and held in an inert gas atmosphere or in a vacuum."

The thermoelectric conversion material of the invention includes a sintered body composed of, as a main component, magnesium silicide ($Mg_2Si$) containing at least one element selected from As, Sb, P, Al, and B. This thermoelectric conversion material is a silicide-based material with less environmental load and has significant advantages such as high thermoelectric conversion performance stable at about 300 to 600°C, high physical strength, resistance to weathering, durability, stability, and reliability.

As, Sb, P, Al, or B at least one of which is contained in the thermoelectric conversion material of the invention is assumed to have a function of facilitating the generation of carries in the thermoelectric conversion material in a sintered state, and therefore high thermoelectric conversion performance is stably obtained. As, Sb, and P are substituted for Si and considered to contribute to the formation of an n-type thermoelectric conversion material. B is substituted for Si and considered to contribute to the formation of a p-type thermoelectric conversion material. Al is substituted for Mg and considered to contribute to the formation of an n-type thermoelectric conversion material.

To allow the thermoelectric conversion material of the invention to have desired performance, it is preferable that each of amounts of As and Sb be 1 to 1000 ppm, each of amounts of P and B be 0.1 to 100 ppm, and the amount of Al be 10 to 10000 ppm.

The present inventors have verified that a thermoelectric conversion material having significantly improved performance can be obtained by allowing both As and Bi to be simultaneously contained therein.

The thermoelectric conversion material of the invention that includes a sintered body composed of, as a main component, magnesium silicide is manufactured by using, as a raw material, one or both of silicon sludge and high-purity silicon and, if necessary, adding thereto a predetermined amount of a dopant.

The high-purity silicon used in the present invention has a purity of seven nines (99.99999%) or higher. Generally, silicon sludge has a purity of about three nines (99.9%). However, in the present invention, the term "silicon sludge" is used to include any low-purity silicon sludge having a purity of less than seven nines (99.99999%).

Silicon sludge, which is produced in a large amount, has a very small particle size of 0.1 to 10 $\mu$m and is difficult to handle. Since the surface area of the fine particles is large, an oxide film is likely to be formed. Moreover, such silicon sludge contains a variety of metal elements and organic and inorganic substances and therefore is generally disposed of in landfill.

In the present invention, high-purity silicon used to manufacture silicon products such as semiconductors and solar cells is used as a raw material, and troublesome silicon sludge can also be used after being subjected to special treatments. According to the invention, a novel thermoelectric conversion material can be manufactured which stably exhibits high thermoelectric conversion performance at about 300 to 600°C and has high physical strength, resistance to weathering, durability, stability, and reliability. The thermoelectric conversion material manufactured by using silicon sludge as a raw material often contains trace amounts of residual elements such as Ti, Ni, Fe, Na, Ca, Ag, Cu, K, Mg, and Zn which are contained in the original silicon sludge in trace amounts. The kinds, number, and amounts of the residual elements differ depending on the type and source of the silicon sludge. However, the inventors have confirmed that any of these elements do not adversely affect the characteristics of the thermoelectric conversion material.

The amounts of the elements contained in the thermoelectric conversion material of the invention are such that: each of amounts of As and Sb are preferably 1 to 1000 ppm; each of amounts of P and B are preferably 0.1 to 100 ppm; and the amount of Al is preferably 10 to 10000 ppm, as described above.

The four elements, As, Sb, P, and Al, are of the n-type, and B is of the p-type. When the thermoelectric conversion material contains two or more of these elements and both the p-type and n-type elements are contained, the type (n- or p-type) of the thermoelectric conversion material is determined by the type (n- or p-type) of the element(s) that is(are) greater in (total) amount.

The silicon sludge used as a raw material for manufacturing the thermoelectric conversion material of the invention is a waste product produced during grinding and polishing of silicon ingots or silicon wafers in manufacturing of silicon. Such waste silicon sludge is produced in large quantity and is therefore easily available. A significant advantage that the environmental load can be reduced can be provided, which makes a valuable contribution to society.

P-type silicon sludge containing B and/or n-type silicon sludge containing As, Sb, or P may be used as the silicon sludge described above.

Such silicon sludge contains a large amount of water that is used in processes of grinding and polishing silicon ingots and silicon wafers. Therefore, it is preferable to subject the silicon sludge to filtration-separation treatment in advance before the thermoelectric conversion material of the invention is manufactured. Silicon sludge having a water content of 10 mass % or less is preferably used.

In addition to the dewatered silicon sludge subjected to filtration-separation treatment in advance, other types of silicon sludge may be used such as: silicon sludge obtained by causing cations to dissolve therein to flocculate suspended particles in the sludge and subjecting the resulting sludge to filtration-separation treatment to reduce the water content to 10 mass % or less; and silicon sludge obtained by flocculating suspended particles in the sludge using an ordinary flocculant such as an organic polymer flocculant, polyaluminum chloride, or aluminum sulfate and subjecting the resulting sludge to filtration-separation treatment to reduce the silicon concentration water content to 10 mass % or less. In this manner, the energy required for dewatering treatment can be reduced, which provides another significant advantage in that the cost is reduced.

The thermoelectric conversion material of the invention is a sintered body of polycrystalline magnesium silicide containing at least one element selected from As, Sb, P, Al, and B. The sintered body obtained by the sintering step is a dense body with no voids in which the magnesium silicide particles are fusion-bonded to each other. The density of the sintered body is 70% or more of the theoretical value, and unreacted Si and Mg, silicon oxide, and magnesium oxide are not present.

As described above, the thermoelectric conversion material of the invention has a non-dimensional performance index (ZT) of 0.5 or more at an operating temperature of 300 to 600°C and high physical strength, stably exhibits high thermoelectric conversion performance at about 300 to 600°C, and has high resistance to weathering, durability, stability, and reliability. These characteristics are considered to be due to the structure and properties described above.

The method for manufacturing a thermoelectric conversion material of the present invention is characterized by sequentially performing the mixing step of using high-purity silicon and/or purified and refined silicon as silicon and mixing magnesium and the silicon, the synthesizing step of synthesizing polycrystalline magnesium silicide ($Mg_2Si$) by melting and reacting the obtained mixture in a sealed condition under a reducing atmosphere, and the firing step of firing the synthesized magnesium silicide. In the mixing step, the synthesizing step, and/or the firing step, at least one element selected from As, Sb, P, Al, and B is added if necessary.

The pulverizing step of pulverizing the synthesized magnesium silicide to form fine particles may be performed before the firing step. This step is further effective for manufacturing the thermoelectric conversion material of the invention that stably exhibits high thermoelectric conversion performance and has high physical strength, resistance to weathering, durability, stability, and reliability.

One of the features of the manufacturing method of the invention is that the final product is not produced in a single step but is produced in separate two steps including the synthesizing step and the firing step. Specifically, magnesium silicide is first synthesized and then fired. In this manner; a highly dense body is generated. This may be the reason for the desired thermoelectric conversion characteristics.

The purified and refined silicon refers to a product obtained by subjecting the silicon sludge filtration-treated in the manner described above to a purifying and refining step described below as a pre-treatment when silicon sludge is used as the raw material for silicon.

The thermoelectric conversion material of the invention contains at least one element selected from As, Sb, P and B. When purified and refined silicon is used as the silicon, if the silicon sludge contains at least one element selected from As, Sb, P and B in an amount sufficient to contribute to the thermoelectric conversion performance, a dopant is not required to be added. If the amount is insufficient, a dopant must be added in an amount corresponding to the shortage.

When high-purity silicon is used, a sufficient amount of at least one element selected from As, Sb, P, and B must be added.

A description is given of the above purifying and refining step.

The silicon sludge is in a form of fine powder and therefore has a large surface area, so that silicon oxide is easily formed as a film on the surface. Such silicon oxide prevents the reaction of Mg and Si in the synthesizing step. When silicon oxide remains contained in the thermoelectric conversion material, the residual silicon oxide causes a reduction in performance. The purifying and refining step is performed to resolve this problem. The purifying and refining step includes: the silicon oxide eliminating step of eliminating silicon oxide generated in the filtration-treated silicon sludge in a reducing atmosphere; and the dewatering step of, when the filtration-treated silicon sludge contains residual water in an amount that causes the generation of silicon oxide, removing the residual water as much as possible. The dewatering step is first performed, followed by the silicon oxide eliminating step.

The silicon oxide eliminating step maybe performed in a dilute aqueous hydrofluoric acid solution instead of a reducing atmosphere. In such a case, the dewatering step must be performed after the silicon oxide eliminating step.

A description is given of the purifying and refining step performed when the silicon oxide eliminating step is performed in a reducing atmosphere.

No particular limitation is imposed on the method used in the dewatering step (I), which is performed if necessary, so long as water does not remain in the silicon sludge to be subjected to the silicon oxide eliminating step. The dewatering step maybe performed in air, vacuum, or a gas atmosphere. Preferably, the dewatering step is performed in a reducing atmosphere containing hydrogen gas and, if necessary, an inert gas. The temperature during the dewatering step is preferably about 80 to about 500°C. It is preferable to perform the dewatering step under reduced pressure because the dewatering time can be reduced.

The silicon oxide eliminating step (II) is performed under reduced pressure in a reducing atmosphere containing hydrogen gas and/or deuterium gas and, if necessary an inert gas at a temperature higher than the temperature for step (I) and is preferably performed at a temperature of about 400 to about 1000°C.

When the silicon oxide eliminating step is performed in dilute aqueous hydrofluoric acid solution, the dewatering step is performed in a manner similar to the above step (I), and the elimination of silicon oxide must be performed at a temperature lower than the temperature during the above step (II).

The mixing ratio of magnesium to silicon in the mixing step in the thermoelectric conversion material manufacturing method of the invention is basically stoichiometrical ratio of Mg : Si being 2 : 1. Practically, in consideration of, for example, the scattering loss of the two elements, the reaction is performed by mixing magnesium and silicon in a ratio of Mg : Si being 2.2 : 0.8 to 1.8 : 1.2, and this is effective for synthesizing Mg$_2$Si having a predetermined purity.

The dopant may be added in the mixing step, synthesizing step, or firing step. To uniformly disperse the dopant in the thermoelectric conversion material, the dopant is preferably added in the mixing step.

In the present invention, purified and refined silicon and high-purity silicon may be used together. Particularly in terms of cost, the mixing ratio of purified and refined silicon/high-purity silicon is preferably 50 to 100 mass % / 50 to 0 mass %.

In the manufacturing method of the invention, silicon oxide prevents the synthesis of magnesium silicide and causes a reduction in the performance of the thermoelectric conversion material, as described above. Therefore, to prevent the generation of silicon oxide, it is preferable to remove water as much as possible in all the steps. Preferably, the mixture obtained in the mixing step is subjected to dewatering treatment. The dewatering treatment is preferably performed at 80 to 500°C under reduced pressure, and the treatment time is, but not limited to, about 2 to 3 hours.

Preferably, the synthesizing step performed after the mixing step is performed in a reducing atmosphere containing hydrogen gas and, if necessary, an inert gas under reducedpressure at a temperature between the melting point of magnesium and the melting point of silicon. In this manner, magnesium and silicon are safely and reliably melted and reacted, whereby polycrystalline magnesium silicide can be synthesized.

The reason for using a reducing atmosphere is that the amount of magnesium oxide must be reduced as much as possible to obtain a sintered body of magnesium silicide (Mg$_2$Si) that has desired properties suitable for a thermoelectric conversion material. To avoid the generation of magnesium oxide, it is important to perform the synthesizing step in an atmosphere in which contact with oxygen is prevented.

Examples of the vessel used for the melting- reaction of the supplied mixture of magnesium and silicon in the synthesizing step include aluminum oxide-made, boron nitride-made, silicon carbide-made, and agate-made vessels and vessels with their surface coated with boron nitride.

When an aluminum oxide-made vessel is used, the Al atoms in the vessel are separated during the reaction, and magnesium silicide containing Al as a dopant is generated.

The synthesized magnesium silicide is then subjected to the sintering step using the pressurizing compression sintering method, whereby the thermoelectric conversion material of the invention exhibiting desired performance is obtained as a sintered body.

However, a dense thermoelectric conversion material having much better performance can be obtained by pulverizing the synthesized magnesium silicide into particle form and then subjecting the particles to the sintering step.

As described above, a p-type silicon sludge containing B and/or an n-type silicon sludge containing As, Sb, or P may be used as the silicon sludge used in the manufacturing method of the invention.

If the p-type silicon sludge used contains B in an amount necessary to act as a dopant, an additional amount of B is not required to be added. If the n-type silicon sludge used contains As, Sb, or P in an amount necessary to act as a dopant, an additional amount of As, Sb, or P is not required to be added. Therefore, advantageously, the desired magnesium silicide can be easily and economically manufactured.

The thermoelectric conversion material of the invention including a sintered body composed of, as a main component, magnesium silicide (Mg$_2$Si) containing at least one element selected from As, Sb, P, Al, and B is a dense body with few voids in which the magnesium silicide particles are fusion-bonded to each other. In addition, unreacted silicon and magnesium, silicon oxide, and magnesium oxide are not present. Therefore, the thermoelectric conversion material stably exhibits high thermoelectric conversion performance at about 300 to 600°C, and has highphysical strength, resistance to weathering, durability, stability, and reliability.

The method for manufacturing a thermoelectric conversion material of the invention is a two-step method. Specifically, first, polycrystalline magnesium silicide is produced by melting a mixture prepared by uniformly mixing silicon and magnesium to allow them to substantially completely react with each other. Subsequently, the produced magnesium silicide is sintered. Therefore, the obtained sintered body contains substantially no unreacted silicon and magnesium and has no voids. Moreover, in the method, silicon sludge from which silicon oxide is eliminated using a special pre-treatment can be used as the silicon.

BRIEF DESCRIPTION OF THE DRAWINGS

Fig. 1(a) is a micrograph of a thermoelectric conversion material of the invention in Example 1 which includes a sintered body obtained by sintering Mg$_2$Si particles at a sintering pressure of 30 MPa. Fig. 1 (b) is a micrograph of a thermoelectric conversion material of the invention in Example 1 which includes a sintered body obtained by sintering Mg$_2$Si particles at a sintering pressure of 17 MPa.

Fig. 2 is a graph of operating temperature versus non-dimensionalized performance index.

Fig. 3 is an explanatory diagram of an exemplary configuration of a thermoelectric conversion element including n-type and p-type thermoelectric conversion members.

Fig. 4 is an explanatory diagram of an exemplary configuration of another thermoelectric conversion element including n-type and p-type thermoelectric conversion members.

Fig. 5 is an explanatory diagram of an exemplary configuration of a thermoelectric conversion element including only an n-type thermoelectric conversion member.

Fig. 6 is an explanatory diagram of an exemplary configuration of another thermoelectric conversion element including only an n-type thermoelectric conversion member.

Fig. 7 is an explanatory diagram of an exemplary configuration of another thermoelectric conversion element including many n-type thermoelectric conversion members.

Fig. 8 shows the results of powder X-Ray diffraction analysis of the thermoelectric conversion material of the invention in Example 1 which includes a sintered body obtained by sintering $Mg_2Si$ particles at a sintering pressure of 30 MPa.

DESCRIPTION OF REFERENCE NUMERALS

| 3 | resistance (load) |
|---|---|
| 4 | DC power supply |
| 5, 6 | electrode |
| 101, 103 | n-type thermoelectric conversion member |
| 102 | p-type thermoelectric conversion member |

BEST MODE FOR CARRYING OUT THE INVENTION

Next, embodiments of the invention will be described in detail.

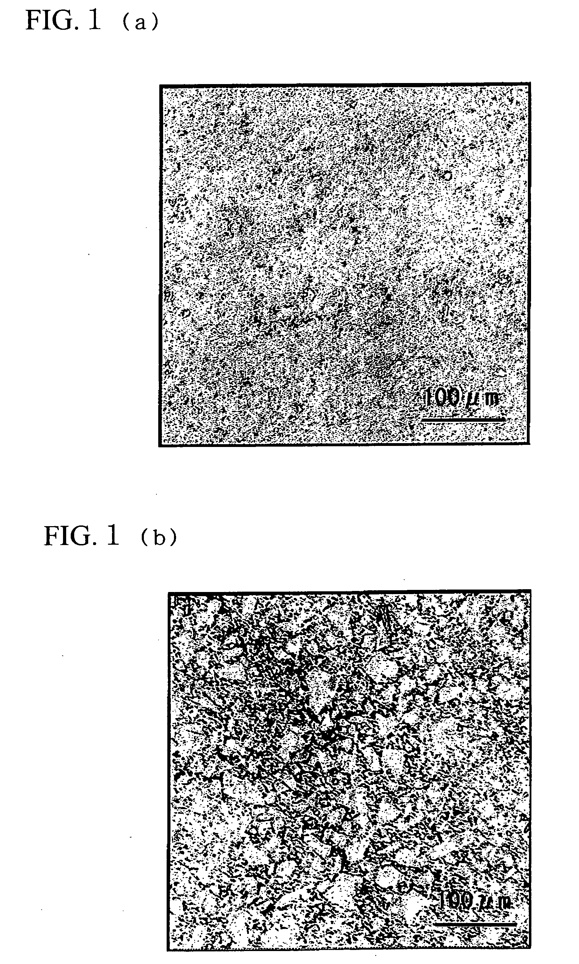

Fig. 1(a) is a micrograph of a thermoelectric conversion material of the invention in Example 1 which includes a sintered body obtained by sintering $Mg_2Si$ particles at a sintering pressure of 30 MPa. Fig. 1 (b) is a micrograph of a thermoelectric conversion material of the invention in Example 1 which includes a sintered body obtained by sintering $Mg_2Si$ particles at a sintering pressure of 17 MPa.

In the thermoelectric conversion material of the invention shown in Fig. 1 (a) (hereinafter referred to as Example 1(a)), most part of the contact surfaces of the particles were fusion-bonded. This thermoelectric conversion material had a density close to the theoretical density (99% of the theoretical density) and high physical strength, exhibited high thermoelectric conversion performance at an operating temperature of about 300 to 600°C with the non-dimensional performance index ZT being about 0.5 or more and 0.8 at the maximum, and had high resistance to weathering, durability, stability, and reliability.

In the thermoelectric conversion material of the invention shown in Fig. 1(b) (hereinafter referred to as Example 1(a)), at least part of the contact surfaces of the particles were fusion-bonded. This thermoelectric conversion material had a density of about 88% of the theoretical density and high physical strength, exhibited high thermoelectric conversion performance at an operating temperature of about 400 to 600°C with the non-dimensional performance index ZT being about 0.4 or more and 0.7 at the maximum, and had high resistance to weathering, durability, stability, and reliability.

As described above, a large amount of waste silicon sludge is produced during grinding or polishing of ingots or wafers made of high purity silicon and used to manufacture silicon products such as semiconductors and solar cells. Such silicon sludge has a very small particle size of 0.1 to 10 $\mu$m, is difficult to handle, and contains, in addition to silicon, various metal elements such as boron, phosphorus, tungsten, chromium, titanium, arsenic, gallium, iron, and oxygen and organic substances such as oils. Further contained is polyaluminum chloride or aluminum sulfate serving as a flocculant.

Examples of the silicon sludge that can be preferably used in the present invention are described below based on generally known criteria of silicon sludge.

Class 1 silicon sludge

Silicon sludge obtained by subjecting, to filtration-separation treatment, waste silicon sludge produced in an end-cutting process for silicon ingots, ingot rough polishing step, slicing step, and chamfering step performed in a silicon wafer manufacturer, and having a silicon concentration of 93 mass %, water content of 7 mass %, B concentration of 0.2 ppm or less, and P concentration of 1 ppm or less.

Class 2 silicon sludge

Silicon sludge obtained by subjecting, to filtration-separation treatment, waste silicon sludge produced in a wafer processing process (mirror polishing and back grinding steps) performed in a semiconductor manufacturer, and having a silicon concentration of 92 to 97 mass %, water content of 3 to 8 mass %, B concentration of 0.2 to 6 ppm, and P concentration of 1 to 70 ppm.

Class 3 silicon sludge

Silicon sludge obtained by subjecting, to filtration-separation treatment, waste silicon sludge produced in a dicing step in a semiconductor assembling process performed in a semiconductor manufacturer, and having a silicon concentration of 95 to 98 mass %, water content of 5 to 2 mass %, B concentration of 6 to 100 ppm, and P concentration of 70 to 1000 ppm.

The high-purity silicon used in the invention has a purity of seven nines or higher and is high-purity silicon used to manufacture silicon products such as semiconductors and solar cells.

Specific examples of the high-purity silicon include high-purity silicon raw materials for LSIs, high-purity silicon raw materials for solar cells, high-purity metal silicon, high-purity silicon ingots, and high purity wafers.

When the thermoelectric conversion material of the invention is manufactured using high-purity silicon as a raw material, doping is performed if necessary.

If necessary, a predetermined amount of dopant is added in at least one step selected from the mixing step of mixing magnesium with high purity silicon in a predetermined magnesium-to-silicon mixing ratio and the firing step of firing the synthesized $Mg_2Si$.

The dopant in the sintered body may be, in whole or in part, a dopant doped by dissolution from reaction apparatuses and the like used for fusion synthesis of $Mg_2Si$ and/or pressurizing compression sintering, so long as a sintered body stably exhibiting high thermoelectric conversion performance can be obtained by pressurizing compression sintering.

When the thermoelectric conversion material of the invention is manufactured using high-purity silicon as a raw material, the same procedure used to manufacture the thermoelectric conversion material using silicon sludge is used except that the purifying and refining step is not performed.

In the present invention, the class 1 to 3 silicon sludges may be used alone or in combination of two or more.

Preferably, in the purifying and refining step in the present invention, the dewatering step and the silicon oxide eliminating step are preformed in combination, as described above. The latter is performed preferably in a reducing atmosphere.

The heating temperature during the dewatering step performed under reduced pressure is preferably 80 to 500°C and particularly preferably 200 to 300°C. When the temperature is less than 80°C, the contained water is not sufficiently removed, and a problem tends to arise in that the generation of silicon oxide and the oxidation of magnesium silicide in the subsequent steps are facilitated, so that the thermoelectric characteristics are impaired. When the temperature is higher than 500°C, the formation of silicon oxide tends to be facilitated due to a temperature rise before the contained water is sufficiently removed, which is not preferred.

The gas used may be 100 percent by volume hydrogen gas. Preferably, a gas mixture containing an inert gas, such as nitrogen or argon, and hydrogen gas in an amount of 5 percent by volume or more and preferably 25 percent by volume or more may be used.

When the amount of hydrogen gas is less than 5 percent by volume, the generation of silicon oxide caused by oxygen or water in the atmospheric gas at high temperature is not suppressed, and the generated silicon oxide is not eliminated. Therefore, a problem tends to arise in that the thermoelectric characteristics of $Mg_2Si$ are impaired, which is not preferred.

Preferably, the heat treatment is performed such that water that facilitates the growth of silicon oxide film preventing the reaction of Mg and Si is removed as sufficient as possible, and the heat treatment time is, for example, about 3 hours.

The supply of gas such as hydrogen gas, once started, may be terminated. For example, the gas is supplied at a flow rate of preferably 500 to 5000 L/min and more preferably 2000 to 4000 L/min.

As describe above, in the dewatering step (I), water that facilitates the growth of silicon oxide film preventing the reaction of Mg and Si can be removed.

The dewatering treatment is advantageously performed in a reducing atmosphere. This is because the generation of silicon oxide ($SiO_2$) must be avoided in order to generate a sinteredbodyof magnesium silicide ($Mg_2Si$) that has desired characteristics suitable for a thermoelectric conversion material. Therefore, it is important to use a mixture not containing water as the mixture describe above and to perform the synthesizing step in a reducing atmosphere.

Next, in the silicon oxide eliminating step (II), preferably, the silicon sludge heat-treated and sufficiently dewatered in step (I) is heat-treated at 400 to 1000°C under reduced pressure in a reducing atmosphere containing 5 percent by volume or more of hydrogen gas and, if necessary, an inert gas. In this manner, silicon oxide is eliminated and reduced to silicon. The thus-prepared silicon is referred to as purified and refined silicon.

This step may be performed under slightly increased pressure or atmospheric pressure. Preferably, in consideration of safety, a slightly reduced pressure of, for example, about 0.08 MPa is used. The heat treatment temperature is preferably 400 to 1000°C and more preferably 500 to 700°C.

When the temperature is less than 400°C, silicon oxide is not sufficiently eliminated and remains present. Therefore, a problem tends to arise in that the thermoelectric characteristics of magnesium silicide are impaired. When the temperature is higher than 1000°C, the formation of silicon oxide is facilitated, which is not preferred. In such a case, silicon oxide is not sufficiently eliminated, so that the thermoelectric characteristics of magnesium silicide are impaired. Moreover, impurities such as titanium and iron may diffuse from the apparatus, atmosphere, and the like into silicon and possibly react therewith.

The gas used may be 100 percent by volume hydrogen gas. Preferably, a gas mixture containing an inert gas, such as nitrogen or argon, and hydrogen gas in an amount of 5 percent by volume or more may be used.

No particular limitation is imposed on the heat treatment time. Preferably, the heat treatment is performed such that silicon oxide is eliminated and reduced to silicon. Forexample, the heat treatment time is about 2 hours.

The supply of gas such as hydrogen gas, once started, may be terminated. The gas is supplied at a flow rate of preferably 50 to 1000 L/min and more preferably 300 to 600 L/min.

As describe above, in the silicon oxide eliminating step (II), the silicon oxide film on Si that prevents the reaction of Mg with Si is eliminated and reduced to silicon, whereby purified and refined silicon is prepared.

The purified and refined silicon is prepared through steps (I) and (II) described above. If necessary, the prepared purified and refined silicon may be subjected to step (III) in which heat treatment is performed in a reducing atmosphere at a temperature lower than the temperature used in step (I). In this manner, the storage stability of the purified and refined silicon canbe improved.

Preferably, the heat treatment in step (III) is performed at 80 to 150°C under reducedpressure in a reducing atmosphere containing 5 percent by volume or more of hydrogen gas and, if necessary, an inert gas.

This step may be performed under slightly increased pressure or atmospheric pressure. Preferably, in consideration of safety, a slightly reduced pressure of, for example, about 0.08 MPa is used. The heat treatment temperature is 80 to 150°C and preferably about 100°C.

The gas used may be 100 percent by volume hydrogen gas. Preferably, a gas mixture containing an inert gas, such as nitrogen or argon, and hydrogen gas in an amount of 5 percent by volume or more maybe used. The supply of gas such as hydrogen gas, once started, may be terminated. Preferably, the gas is supplied at a flow rate of, for example, 1000 L/min.

The purified and refined silicon must be stored so as not to be oxidized between steps (I) and (II) and/or between steps (II) and (III) and before the mixing step. In a preferred storage method, the purified and refined silicon packed in a container is stored in an inert gas atmosphere or vacuum.

Preferably, the above steps (I) to (III) are performed continuously in a single heat treatment apparatus (for example, a commercially available electric furnace). However, these steps may be performed in different heat treatment apparatuses.

Next, in the mixing step, magnesium is mixed with the prepared purified and refined silicon. If the characteristics of magnesium silicide must be improved, a dopant is appropriately added.

Preferably, the amount of magnesium mixed with the purified and refined silicon in the mixing step is determined such that the atomic mixing ratio of Mg : Si is 2.2 : 0.8 to 1.8 : 1.2. The mixing ratio in the above range is also used for high-purity silicon.

A mixture of the purified and refined silicon and high-purity silicon may be used. In such a case, in consideration of cost, a large amount of purified and refined silicon may be used. However, it should be considered that the purified and refined silicon is used in an amount of 100 mass %. Accordingly, the mixing ratio of purified and refined silicon to high-purity silicon is suitably 50 to 100 mass % / 50 to 0 mass %. The mixing ratio of the amount of magnesium to the total amount of the two types of silicon (Mg : Si) is suitably 2.2 : 0.8 to 1.8 : 1.2. Also in this case, a dopant may be added if necessary.

Various flocculation methods and apparatuses are described in Patent Documents 2 to 4. In one method, magnesium sulfate, magnesium oxide, magnesium hydroxide, magnesium carbonate, or the like is used to cause cations (magnesium ions) to dissolve in a polluted liquid, whereby the suspended silicon particles in the liquid are flocculated. In another method and apparatus, a material generating cations (magnesium ions) (such as magnesium sulfate, magnesium oxide, magnesium hydroxide, or magnesium carbonate) is placed in a vessel, a waste silicon sludge solution is caused to pass through the vessel so as to come into contact with the above material, and cations (magnesium ions) are caused to dissolve in the solution to flocculate the suspended silicon particles in the solution. When such methods and apparatuses are used, the flocculated product contains magnesium. Therefore, these methods and apparatuses are advantageous in that, for example, when the amount of Mg in the flocculated product is insufficient, only an additional amount of Mg is added such that the atomic mixing ratio of Mg : Si is 2.2 : 0.8 to 1.8 : 1.2.

Examples of the silicon raw material for semiconductors which is used in the invention include: the above-described class 1 silicon sludge containing waste high-purity silicon produced in an end-cutting process for silicon ingots, ingot rough polishing step, slicing step, and chamfering step performed in silicon wafer manufacturers; high-purity silicon raw materials for LSIs; high-purity silicon raw materials for solar cells, and high-purity metal silicon. With such materials, Mg and Si are easily mixed such that the mixing ratio of Mg : Si is 2.2 : 0.8 to 1.8 : 1.2, and the amount of the dopant is easily controlled.

Next, water that facilitates the growth of oxide film preventing the reaction of Mg with Si must be removed from the mixture obtained in the mixing step. Preferably, to remove the water easily and reliably, the mixture is subj ected to dewatering treatment under reduced pressure for 2 to 3 hours at 80 to 500°C and preferably 200 to 300°C.

When the heat treatment temperature is less than 80°C, water may not be removed sufficiently. When the temperature is abruptly increased above 500°C, the growth of silicon oxide film is facilitated, which is not preferred.

To remove water reliably, the degree of vacuum is in the range of preferably $10^{-2}$ to $10^{-5}$ Pa. More preferably, the dewatering is performed at 150°C or higher for 2 hours or longer.

Next, the dewatered mixture is melted in a reducing atmosphere to react Mg with Si, whereby magnesium silicide ($Mg_2Si$) is synthesized.

Preferably, in the synthesizing step, the dewatered mixture is heat-treated in a reducing atmosphere under reduced pressure at a temperature between the melting point of magnesium and the melting point of silicon to thereby fusion-synthesize $Mg_2Si$. Particularly, the synthesizing step is preferably performed in a reducing atmosphere containing 5 percent by volume or more of hydrogen gas and, if necessary, an inert gas.

With this method, Si and Mg are safely and reliably reacted to synthesize magnesium silicide.

The synthesizing step maybe performed under slightly increased pressure or atmospheric pressure. Preferably, in consideration of safety, a slightly reduced pressure of, for example, about 0.08 MPa is used.

The heat treatment temperature is 700°C to 1410°C (the melting point of silicon) and preferably 1085°C (the melting point of $Mg_2Si$) to 1410°C (the melting point of silicon), and the heat treatment is performed for, for example, about 3 hours.

When the mixture is heated to the melting point of Mg (693°C) or higher to melt Mg, Si dissolves in the molten Mg, and the reaction is started. However, the reaction rate is slightly slow.

When the temperature exceeds the boiling point of Mg (1090°C), Mg may be abruptly vaporized and scattered. Therefore, the synthesis must be performed with care.

The gas used may be 100 percent by volume hydrogen gas. Preferably, a gas mixture containing an inert gas, such as nitrogen or argon, and hydrogen gas in an amount of 5 percent by volume or more may be used.

The reason for performing the synthesizing step in a reducing atmosphere is that, to obtain a sintered body of magnesium silicide ($Mg_2Si$) having desired characteristics suitable for a thermoelectric conversion material, not only silicon oxide ($SiO_2$) but also magnesium oxide must be contained as small as possible. Therefore, to avoid the generation of magnesium oxide produced by oxidation of magnesium, the synthesizing step is performed in a reducing atmosphere.

The synthesized magnesium silicide is cooled to give polycrystalline magnesium silicide. Natural cooling, forced cooling, or a combination thereof may be used.

In the present invention, the desired thermoelectric conversion material can be obtained by direct sintering of magnesium silicide obtained in the synthesizing step. However, a thermoelectric conversion material having improved characteristics can be obtained by pulverizing $Mg_2Si$ before the sintering treatment to form particles and sintering the obtained particles to generate a sintered body. The sintering step is described below.

Preferably, pulverization is performed so as to give fine magnesium silicide particles of fairly uniform size and narrow size distribution. When such fine particles of fairly uniform size and narrow size distribution are sintered using the pressuring compression sintering method, at least part of the surfaces of the particles are fusion-bonded to each other, and the particles are preferably sintered to the extent that substantially no voids are observed. In this manner, a sintered body having a density of about 70% to about 100% of the theoretical density can be obtained.

The obtained sintered body has high physical strength, stably exhibits high thermoelectric conversion performance, and can be used as a thermoelectric conversion material having high resistance to weathering, durability, stability, and reliability.

The pulverized magnesium silicide has an average particle size of 0.1 to 100 $\mu$m, preferably 5 to 50 $\mu$m, and more preferably 0.1 to 0.2 $\mu$m. Specifically, for example, particles passing a 75 $\mu$m sieve and retained on a 65 $\mu$m sieve or particles passing a 30 $\mu$m sieve and retained on a 20 $\mu$m sieve can be used.

If necessary, a predetermined amount of dopant is added to the 0.1 to 0.2 $\mu$m powder obtained in the pulverizing step, and then the powder can be sintered using the pressurizing compression sintering method.

In the synthesizing step, the dopant can be added up to its solubility limit at thermal equilibrium. However, if the dopant must be added beyond the solubility limit, the dopant may be added in the sintering step which is performed under non-thermal equilibrium state. According to the observation made by the inventors, the particle size does not substantially depend on the sintering pressure and temperature, and this is common to purified and refined silicon and high-purity silicon.

The following method is preferably used in the sintering step because a good sintered body having a density of about 70% to about 100% of the theoretical density can be obtained and because a thermoelectric conversion material stably exhibiting high thermoelectric conversion performance and having high physical strength, resistance to weathering, durability, stability, and reliability can be manufactured.

In the sintering step, if necessary, a predetermined amount of dopant is added to magnesium silicide, and then sintering is performed at a sintering pressure of 5 to 60 MPa and a sintering temperature of 600 to 1000°C in a reducing pressure using the pressurizing compression sintering. This process is performed regardless of whether the magnesium silicide has been subjected to the pulverizing step.

When the sintering pressure is less than 5 MPa, a sintered body having a sufficient density of about 70% or more of the theoretical density is difficult to obtain. The obtained sintered body cannot serve as a sample suitable for practical use due to its insufficient strength. Although a sample sintered body having a density close to the theoretical density can be obtained at a sintering pressure of about 60 MPa, a sintering pressure higher than 60 MPa is not practical because the cost for the apparatus is high.

When the sintering temperature is lower than 600°C, it is difficult to obtain a sintered body which is fired with at least part of the contact surfaces of the particles fusion-bonded to each other and has a density in the range of 70% of the theoretical density to a value close to the theoretical density. The strength of the obtained sintered body cannot serve as a sample suitable for practical use due to its insufficient strength. When the sintering temperature exceeds 1000°C or even 1090°C (the boiling point of Mg), not only the sample is damaged because the temperature is too high, but also Mg may be abruptly vaporized and scattered.

For example, in the sintering temperature range of 600 to 800°C, sintering can be preferably performed by setting the sintering pressure to a high value near 60 MPa when the sintering temperature is a low temperature near 600°C or by setting the sintering pressure to a low value near 5 MPa when the sintering temperature is a high temperature near 800°C. In such cases, the sintering is favorably performed for about 5 to 60 minutes and normally about 10 minutes. In this manner, a sintered body having high physical strength and a density close to the theoretical density and stably exhibiting high thermoelectric conversion performance can be obtained.

The presence of air in the atmosphere used during pressurizing compression sintering is not preferred because the air causes oxidation. Therefore, pressurizing compression sintering is performed preferably in an atmosphere of an inert gas such as nitrogen or argon and more preferably in an atmosphere with a degree of vacuum of about 10 Pa.

The pressurizing compression sintering method used in the sintering step is preferably the hot pressing (HP) sintering method or the hot isostatic pressing (HIP) sintering method and more preferably the spark plasma sintering method.

The spark plasma sintering method is one type of pressuring compression method using the DC pulse current method. In this method, a large pulse current is applied to a material to heat and sinter the material. The principle of the method is that a current is applied to a conductive material such as metal or graphite and the material is processed and treated using Joule heat.

Specific examples of the dopant include trivalent dopants, such as B, Al, Ga, and In, doped in divalent Mg site. $Mg_2Si$ used as an n-type thermoelectric conversion material can be manufactured by adding a necessary amount of at least one of these dopants.

Other examples include pentavalent dopants, such as P and Bi, doped in tetravalent Si site. $Mg_2Si$ used as an n-type thermoelectric conversion material can be manufactured by adding a necessary amount of at least one of these dopants.

Other examples include monovalent dopants, such as Ag, Cu, and Au, doped in divalent Mg site. $Mg_2Si$ used as a p-type thermoelectric conversion material can be manufactured by adding a necessary amount of at least one of these dopants.

Other examples include trivalent dopants, such as B, Al, Ga, and In, doped in tetravalent Si site. $Mg_2Si$ used as a p-type thermoelectric conversion material can be manufactured by adding a necessary amount of at least one of these dopants.

When the trivalent dopant such as B, Al, Ga, or In is doped in divalent Mg site, $Mg_2Si$ used as an n-type thermoelectric conversion material can be manufactured. When such a trivalent dopant is doped in tetravalent Si site, $Mg_2Si$ used as a p-type thermoelectric conversion material can be manufactured. However, the substitution site, including the divalent Mg site or tetravalent Si site, of the trivalent dopant depends on the synthesis process and the crystallinity of the obtained sample.

A necessary amount of a suitable dopant is added in accordance with need.

Specifically, the class 1 to 3 silicon sludges may be used alone or in combination of two or more. When a dopant originating from silicon sludge is present, so that a sintered body stably exhibiting high thermoelectric conversion performance can be obtained by pressuring compression sintering without adding any dopant, the addition of dopant is not required.

The dopant in the sintered body may be, in whole or in part, a dopant doped by dissolution from reaction apparatuses and the like used for fusion synthesis of $Mg_2Si$ and/or pressurizing compression sintering, so long as a sintered body stably exhibiting high thermoelectric conversion performance can be obtained by pressurizing compression sintering.

Next, a description is given of a powder for the thermoelectric conversion material of the invention including, as a main component, magnesium silicide ($Mg_2Si$) containing at least one of As, Sb, P, and B.

The powder for the thermoelectric conversion material of the invention including, as a main component, magnesium silicide containing at least one of As, Sb, P,' and B can be manufactured as follows. First, $Mg_2Si$ is synthesized using silicon sludge and/or high-purity silicon as a raw material. At this time, a predetermined amount of dopant is added if necessary. After cooled, the obtained $Mg_2Si$ is sintered without pulverization.

If necessary, a predetermined amount of dopant is added in the mixing step of mixing magnesium with high purity silicon in a predetermined magnesium-to-silicon mixing ratio or in other step.

The dopant in the sintered body may be, in whole or in part, a dopant doped by dissolution from reaction apparatuses and the like used for congruently melt synthesis of $Mg_2Si$ or the like, so long as a sintered body stably exhibiting high thermoelectric conversion performance can be obtained by congruently melt molding or pressurizing compression sintering.

The silicide-based thermoelectric conversion material of the invention can be manufactured by congruently melt molding or pressurizing compression firing using the powder for the thermoelectric conversion material of the invention as a raw material. The thermoelectric conversion material exhibits high thermoelectric conversion performance, has high physical strength, resistance to weathering, durability, stability, and reliability, and imposes less load on the environment.

When the pulverized $Mg_2Si$ powder is subjected to fusionmolding, no particular limitation is imposed on the particle size of the powder, and the powder may be in a granular or powder form. However, when the pulverized $Mg_2Si$ powder is subjected to firing, an $Mg_2Si$ powder composed of particles passing a 75 $\mu$m sieve and retained on a 65 $\mu$m sieve, an $Mg_2Si$ powder composed of particles passing a 30 $\mu$m sieve and retained on a 20 $\mu$m sieve, or an $Mg_2Si$ powder having an average particle size of 5 to 10 $\mu$m and preferably 0.1 to 0.2 $\mu$m, for example, may be preferably used. Two or more types of these powders may also be preferably used in combination.

A thermoelectric conversion element can be produced using a combination of one type of magnesium silicide used as the n-type thermoelectric conversion material of the invention and another type of magnesium silicide used as the p-type thermoelectric conversion material or a p-type thermoelectric conversion material of the invention other than magnesium silicide. Specifically, as shown in Figs. 3 and 4, in this thermoelectric conversion element, electrodes 5 and 6 are disposed on the upper and lower ends of an n-type thermoelectric conversion member 101 and a p-type thermoelectric conversion member 102 arranged in parallel to each other. The electrodes 5 on the upper ends of the thermoelectric conversion members 101 and 102 are connected and integrated together, and the electrodes 6 on the lower ends of the thermoelectric conversion members 101 and 102 are separated from each other.

An electromotive force can be generated between the electrodes 5 and 6 by creating a temperature difference therebetween.

Conversely, when a direct current is applied between the electrodes 6 on the lower ends of the thermoelectric conversion members 101 and 102, heat generation or absorption occurs at the electrodes 5 and 6.

Another thermoelectric conversion element can be produced by using magnesium silicide used as the n-type thermoelectric conversion material of the invention. Specifically, in this thermoelectric conversion element, electrodes 5 and 6 are disposed on the upper and lower ends of an n-type thermoelectric conversion member 103, as shown in Fig. 5.

An electromotive force can be generated between the electrodes 5 and 6 by creating a temperature difference therebetween.

On the other hand, as shown in Fig. 6, when a direct current is applied from a DC power supply 4 so as to flow from the electrode 6 to the electrode 5 through the n-type thermoelectric conversion member 103, heat absorption and heat generation occur at the electrodes 5 and 6, respectively.

Conversely, when a direct current is applied from the DC power supply 4 so as to flow from the electrode 5 to the electrode 6 through the n-type thermoelectric conversion member 103, heat generation and heat absorption occur at the electrodes 5 and 6, respectively.

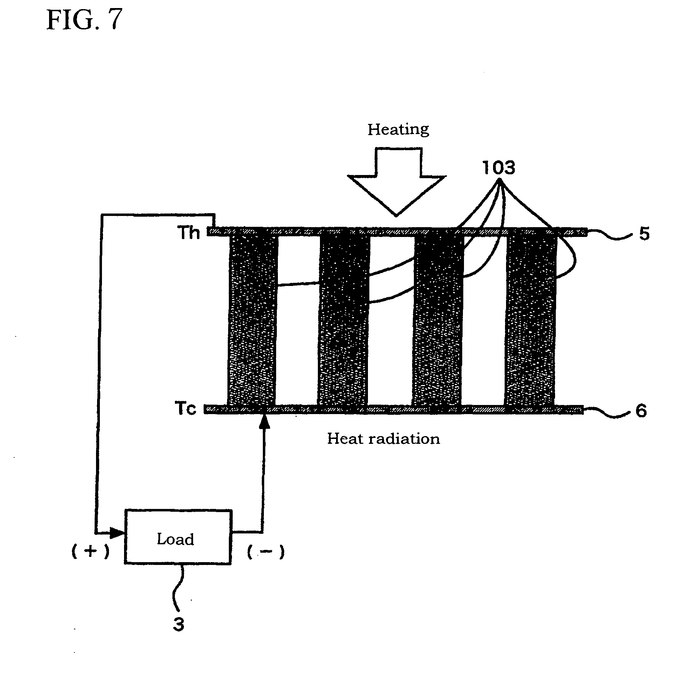

Fig. 7 shows a modification of the thermoelectric conversion element shown in Fig. 5 including the electrodes 5 and 6 disposed on the upper and lower ends of the n-type thermoelectric conversion member 103. This modified thermoelectric conversion element includes a plurality of the n-type thermoelectric conversion members 103 arranged in parallel and the electrodes 5 and 6 disposed on the upper and lower ends thereof.

An electromotive force can be generated between the electrodes 5 and 6 by creating a temperature difference therebetween.

The thermoelectric conversion element shown in Fig. 7 can provide a high current value. Even when one of the plurality of thermoelectric conversion elements is, for example, damaged and not operable, the rest of the plurality of thermoelectric conversion elements are operable. The thermoelectric conversion element can be advantageously continued to be used without a significant reduction in its thermoelectric conversion performance.

The description of the above embodiments has been presented for the purpose of description of the present invention and is not intended to limit the invention described in the claims or to reduce the scope of the invention. The construction and arrangement of the parts of the invention are not limited to the above embodiments and may be variously modified within the technical scope described in the claims.

Next, the present invention will be described in detail by way of Examples and Comparative Example, but the invention is not limited to the Examples so long as the gist of the invention is not changed.

(Example 1)

Waste silicon sludge produced in the dicing step of a semiconductor assembling process performed in a semiconductor manufacture was subjected to filtration-separation treatment using a collecting apparatus (Aqua Closer, product of SANYO Electric Co. , Ltd.) and a filter press (product of PARKER ENGINEERING CO., LTD.), whereby class 3 silicon sludge having a silicon concentration of 95 mass % and a water content of 5 mass % was obtained. The class 3 silicon sludge was subjected to analysis and confirmed to contain B in a concentration of 100 ppm and p in a concentration of 1,000 ppm.

Next, the dewatering step in the purifying and refining step was performed. The class 3 silicon sludge was placed in a commercial electric furnace. The sludge was then subjected to heat treatment at 250°C in air for 3 hours while argon gas containing 5 percent by volume of hydrogen gas was supplied at 3000 L/min to thereby remove water.

Subsequently, the silicon oxide eliminating step in the purifying and refining step was performed. The dewatered silicon sludge was heat-treated in the same electric furnace at 500°C in air for 2 hours while argon gas containing 5 percent by volume of hydrogen gas was supplied at 500 L/min. In this manner, silicon oxide was eliminated and reduced to silicon, whereby purified and refined silicon was obtained.

Next, magnesium was mixed with the thus-obtained purified and refined silicon such that the atomic maxing ratio of Mg : Si was 2 : 1 to give a mixture having a total weight of 1.4 g. The magnesium raw material used was flake-like magnesium (product of Furuuchi Chemical Corporation) having a purity of 99.95% and a size of 2 to 5 mm.

The mixture was subjected to dewatering treatment in the electric furnace under the conditions of $10^{-4}$ Pa at 250°C for 2 hours.

Next, the synthesizing step was performed. The dewatered mixture was placed in an $Al_2O_3$-made melting crucible and allowed to melt and react at 1100°C in air in a reducing atmosphere of argon gas containing 5 percent by volume of hydrogen gas for 3 hours to synthesize magnesium silicide ($Mg_2Si$).

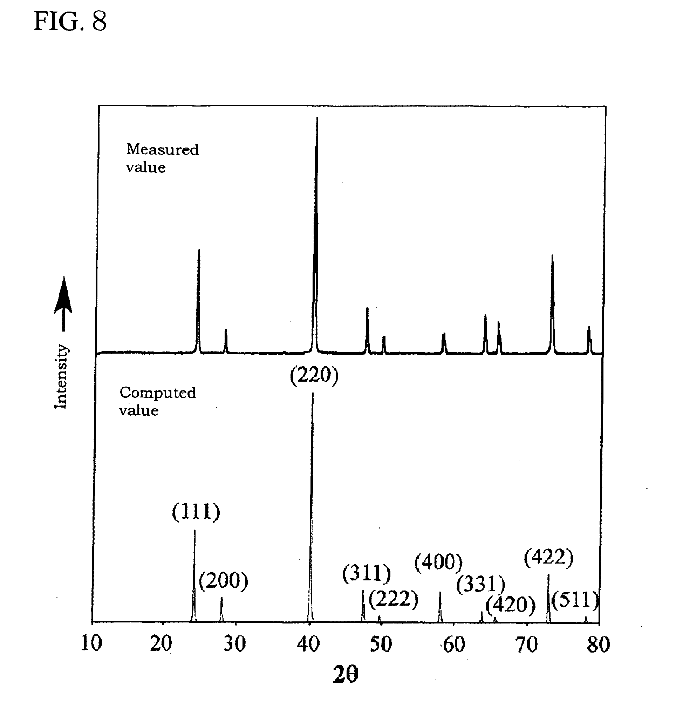

The product was allowed to naturally cool and analyzed. As is clear from the X-ray diffraction data shown in Fig. 8, the obtained magnesium silicide was polycrystalline.

The thus-obtained polycrystalline magnesium silicide was pulverized and sieved through a 30 $\mu$m mesh to give a fine powder having an average particle size of 0.1 $\mu$m and a narrow particle size distribution.

1.400 g of the powder obtained by pulverizing the polycrystalline magnesium silicide was subjected to spark plasma sintering in a vacuum atmosphere of 10 Pa at a sintering pressure of 30 Mpa or 17 Mpa and a sintering temperature of 800°C for a holding time of 10 minutes using a spark plasma sintering apparatus (ED-PAS IIIs, product of ELENIX Inc.), whereby a sintered body having a diameter of 15 mm and a height of 10 mm was obtained.

The density of the obtained sintered body was 99% of the theoretical density when the sintering pressure was 30 MPa and 88% of the theoretical density when the sintering pressure was 17 MPa.

The obtained sintered body was successively polished with diamond abrasive grains of 9 $\mu$m, 3 $\mu$m, and 1 $\mu$m, and the degree of aggregation of crystal grains was observed under a metallurgical microscope.

Fig. 1(a) shows the results of the microscopic observation of the sample produced at a sintering pressure of 30 MPa, and Fig. 1 (b) shows the results of the microscopic observation of the sample produced at a sintering pressure of 17 MPa. The obtained samples are denoted as Examples 1(a) and (1b), respectively.

Each of the obtained sintered bodies was analyzed by glow discharge mass spectrometry (GDMS). The results showed that the sintered body contained 540 ppm of Al originating from the $Al_2O_3$-made melting crucible, 250 ppm of As, and 60 ppm of P.

From the analysis results, it was confirmed that the sintered body contained trace amounts of the following impurity elements.

B: 2 ppm, Sb: 20 ppm, Fe: 3 ppm, Ti: 0.5 ppm,
Ni: 0.3 ppm, Cu: 5 ppm, Ca: 0.2 ppm

Each of the obtained sintered bodies was measured for $\alpha$, $\kappa$, and $\rho$ (Seebeck coefficient (thermoelectromotive force), thermal conductivity, and specific resistance, respectively) in the operating temperature range of 50 to 600°Cusing a thermoelectromotive force-electric conductivity measurement apparatus (ZEM2, ULVAC-RIKO, Inc.) and a laser flash method thermal conductivity measuring system (TC-7000H, ULVAC-RIKO, Inc.).

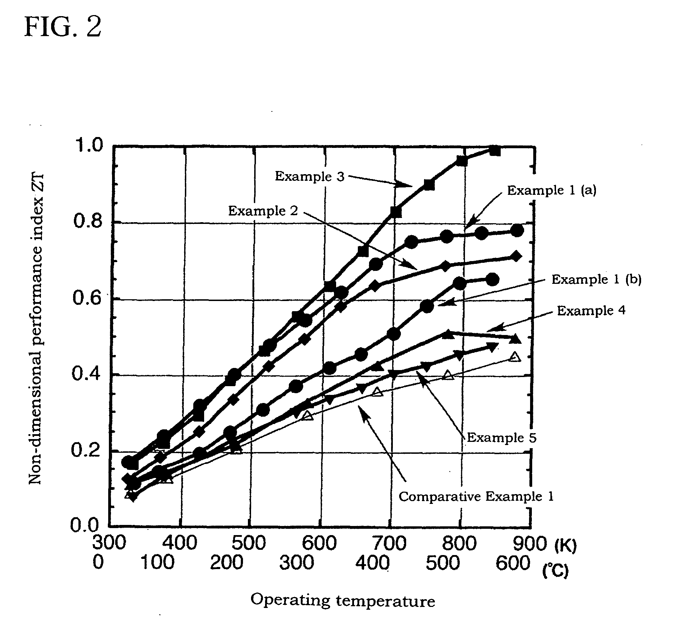

The performance index Z was computed from the measured $\alpha$, $\kappa$, and p using the above-described equation (1), and the non-dimensional performance index ZT was computed by multiplying the performance index Z by temperature T. The results are shown in Fig. 2.

From the obtained ZT values, it was confirmed that each of the obtained sintered bodies was ann-type thermoelectric conversion material suitable for practical use in the operating temperature range of 300 to 600°C.

It was also confirmed that the above impurity elements contained in the obtained sintered bodies do not have any influence on the data.

(Example 2)

Waste silicon sludge produced in a wafer processing process (mirror polishing and back grinding steps) performed in a semiconductor manufacture was subjected to filtration-separation treatment to prepare sludge having a silicon concentration of 92 mass % and a water content of 8 mass %. The analysis revealed that the prepared sludge was class 2 silicon sludge having a B concentration of 6 ppm and a P concentration of 70 ppm.

The same procedure as in Example 1 was followed except that the obtained sludge was used and a sintering pressure of 30 MPa was used to give a sintered body (not doped).

The obtained sintered body was analyzed in the same manner as in Example 1. The results showed that the sintered body contained 90 ppm of Al originating from the $Al_2O_3$-made melting crucible, 240 ppm of As, 8 ppm of P, and 4 ppm of B.

The density of the obtained sintered body was 99% of the theoretical density.

The non-dimensional performance index ZT of the obtained sintered body was computed in the same manner as in Example 1. The results are shown in Fig. 2.

From the obtained ZT values, it was confirmed that the obtained sintered body was an n-type thermoelectric conversion material suitable for practical use in the operating temperature range of 300 to 600°C.

(Example 3)

Waste silicon sludge produced in a wafer processing process (mirror polishing and back grinding steps) performed in a semiconductor manufacture was subjected to filtration-separation treatment to prepare sludge having a silicon concentration of 92 mass % and a water content of 8 mass %. The analysis revealed that the prepared sludge was class 2 silicon sludge having a B concentration of 6 ppm and a P concentration of 70 ppm.

Next, the dewatering step in the purifying and refining step was performed. The silicon sludge was subjected to heat treatment in a commercial electric furnace at 250°C in air for 3 hours while argon gas containing 5 percent by volume of hydrogen gas was supplied at 3000 L/min to thereby remove water.

Subsequently, the silicon oxide eliminating step in the purifying and refining step was performed. The dewatered silicon sludge was heat-treated in the same electric furnace at 500°C in air under reduced pressure for 2 hours while argon gas containing 5 percent by volume of hydrogen gas was supplied at 500 L/min. In this manner, silicon oxide was eliminated and reduced to produce purified and refined silicon.

Magnesium was mixed with the thus-obtained purified and refined silicon such that the atomic mixing ratio of Mg : Si was 2 : 1.

Then, 3 atomic % of Bi serving as an n-type dopant was added to the mixed powder.

Subsequently, the mixture obtained in the mixing step was dewatered under the conditions of $10^{-4}$ Pa and 250°C for 2 hours.

Next, the synthesizing step was performed. The dewatered mixture was placed in an $Al_2O_3$-made melting crucible and allowed to melt and react at 1100°C in air in a reducing atmosphere of argon gas containing 5 percent by volume of hydrogen gas for 3 hours to synthesize magnesium silicide.

The obtained magnesium silicide was allowed to naturally cool and analyzed. The analysis revealed that the produced magnesium silicide was polycrystalline.

Subsequently, the obtained polycrystalline magnesium silicide was subjected to the sintering step. The same procedure as in Example 1 was followed except that a sintering pressure of 30 MPa was used to give a sintered body.

The density of the obtained sintered body was 99% of the theoretical density.

The obtained sintered body was analyzed in the same manner as in Example 1. The analysis revealed that the sintered body contained 240 ppm of Al, 240 ppm of As, 70 ppm of P, 6 ppm of B, and 3 atomic % of Bi.

The non-dimensional performance index ZT of the obtained sintered body was computed in the same manner as in Example 1. The results are shown in Fig. 2.

From the obtained ZT values, it was confirmed that the obtained sintered body was an n-type thermoelectric conversion material suitable for practical use in the operating temperature range of 300 to 600°C.

(Example 4)

Waste silicon sludge produced in an end-cutting process for silicon ingots, ingot rough polishing step, slicing step, and chamfering step performed in a silicon wafer manufacturer was subjected to filtration-separation treatment in the same manner as in Example 1 to prepare sludge having a silicon concentration of 93 mass % and a water content of 7 mass %. The obtained sludge was analyzed, and it was confirmed that the sludge contained 0.2 ppm of B and 0.1 ppm of P.

The same procedure as in Example 1 was followed except that the class 1 sludge was used and a sintering pressure of 30 MPa was used to give a sintered body (not doped).

The density of the obtained sintered body was 99% of the theoretical density.

The obtained sintered body was analyzed, and it was confirmed that the sintered body contained 70 ppm of Al originating from the $Al_2O_3$-made melting crucible, 0.1 ppm of P, and 0.01 ppm of B.

The non-dimensional performance index ZT of the obtained sintered body was computed in the same manner as in Example 1. The results are shown in Fig. 2.

From the obtained ZT values, it was confirmed that the obtained sintered body was an n-type thermoelectric conversion material suitable for practical use in the operating temperature range of 300 to 600°C.

(Example 5)

The same procedure as in Example 3 was followed except that high-purity silicon powder (100%) was used to give a sintered body (having been doped).

The density of the obtained sintered body was 99% of the theoretical density.

The obtained sintered body was analyzed. The results showed that the sintered body contained 70 ppm of Al originating from the $Al_2O_3$-made melting crucible, 0.1 ppm of P, 0.01 ppm of B, and 3 atomic % of Bi.

The non-dimensional performance index ZT of the obtained sintered body was computed in the same manner as in Example 1. The results are shown in Fig. 2.

From the obtained ZT values, it was conf irmed that the obtained sintered body was an n-type thermoelectric conversion material suitable for practical use at an operating temperature of 500°C or higher.

(Comparative Example 1)

A high purity silicon powder (100%) obtained by pulverizing a silicon wafer (a high-purity silicon raw material was used for the grown crystal) used in a silicon wafer manufacturer was used. Magnesium was mixed with the silicon such that the atomic mixing ratio of Mg : Si was 2:1. The mixture was subjected to dewatering treatment in an electric furnace under the conditions of $10^{-4}$ Pa and 250°C for 2 hours in the same manner as in Example 1. Next, the synthesizing step was performed. The dewatered mixture was placed in an $Al_2O_3$-made melting crucible and allowed to melt at 1100°C in a reducing atmosphere of argon gas containing 5 percent by volume of hydrogen gas for 3 hours to synthesize magnesium silicide ($Mg_2Si$), whereby polycrystalline magnesium silicide was obtained.

The thus-obtained polycrystalline magnesium silicide was pulverized to give a polycrystalline magnesium silicide powder passing 200 $\mu$m.

15 g of the powder obtained by pulverizing the polycrystalline magnesium silicide was placed in an $Al_2O_3$-made growth crucible and sealed in a reducing atmosphere of argon gas containing 5 percent by volume of hydrogen gas at 0.08 MPa.

After sealing, the powder was held in an electric furnace at 1, 100°C for 2 hours, and a crystal was grown using the vertical Bridgman crystal growth method by cooling the growth crucible from its end at a rate of 3 mm/h, whereby polycrystalline magnesium silicide (not doped) grown to a diameter of 18 mm and a height of 30 mm was obtained.

The obtained sintered body was analyzed. The results showed that 80 ppm of Al originating from the $Al_2O_3$-made melting crucible was doped to the magnesium silicide and 9 ppm of P, 1 ppm of B, 0.05 ppm of As, and 0.01 ppm of Sb were also doped.

The non-dimensional performance index ZT of the obtained sintered body was computed in the same manner as in Example 1. The results are shown in Fig. 2.

From the obtained ZT values, it was confirmed that the thermoelectric conversion performance of the obtained sintered body was low and its practicality is low.

As can be seen from Fig. 2, the sintered body of Example 1 (a) exhibits high thermoelectric conversion performance corresponding to a non-dimensional performance index ZT of 0.5 to 0.8 at an operating temperature of about 300 to 600°C.

Similarly, as can be seen from Fig. 2, the sintered body of Example 2 exhibits high thermoelectric conversion performance corresponding to a non-dimensional performance index ZT of 0.5 to 0.8 at an operating temperature of about 300 to 600°C.

As can be seen from Fig. 2, the sintered body of Example 3 exhibits high thermoelectric conversion performance corresponding to a non-dimensional performance index ZT of 0.5 to 1.0 at an operating temperature of about 300 to 600°C.

As can be seen from Fig. 2, the sintered body of Example 1 (b) exhibits high thermoelectric conversion performance corresponding to a non-dimensional performance index ZT of 0.4 to 0.7 at an operating temperature of about 400 to 600°C. These values indicate that the $Mg_2Si$ is sufficient for practical use as an n-type thermoelectric conversion material at an operating temperature of about 400 to 600°C.

As can be seen from Fig. 2, the sintered body of Example 4 exhibits thermoelectric conversion performance corresponding to a non-dimensional performance index ZT of 0.3 to 0. 5 at an operating temperature of about 300 to 600°C. These values indicate that the $Mg_2Si$ is sufficient for practical use as an n-type thermoelectric conversion material at an operating temperature of about 500°C or higher.

As can be seen from Fig. 2, the sintered body of Example 5 exhibits thermoelectric conversion performance corresponding to a non-dimensional performance index ZT of 0.2 to 0.4 at an operating temperature of about 300 to 600°C. These values indicate that the $Mg_2Si$ is sufficient for practical use as an n-type thermoelectric conversion material at an operating temperature of about 500°C or higher.

However, the sintered body of Comparative Example 1 has a non-dimensional performance index ZT of 0.2 to 0.3 at an operating temperature of about 300 to 600°C. Therefore, the thermoelectric conversion performance is low, and the practicality is low.

INDUSTRIAL APPLICABILITY

The thermoelectric conversion material of the invention is characterized by containing, as a main component, $Mg_2Si$ (magnesium silicide) containing at least one of As, Sb, P, and B.

The thermoelectric conversion material is a silicide-based thermoelectric conversion material with less environmental load and is manufactured using, as a raw material, pure silicon and/or waste silicon sludge that is produced in a large amount but has had to be disposed of in landfill because it contains many metal elements and organic and inorganic substances. The thermoelectric conversion material has significant advantages such as high thermoelectric conversion performance stable at about 300 to 600°C, high physical strength, resistance to weathering, durability, stability, and reliability. Therefore, the thermoelectric conversion material has broad industrial applicability.

**Claims**

1. A thermoelectric conversion material comprising a sintered body composed of, as a main component, polycrystalline magnesium silicide ($Mg_2Si$) containing at least one element selected from As, Sb, P, Al, and B.

2. The thermoelectric conversion material according to claim 1, wherein a silicon component of the magnesium silicide is made from silicon sludge as a raw material.

3. The thermoelectric conversion material according to claim 1 or 2, wherein each of amounts of As and Sb is 1 to 1000 ppm, each of amounts of P and B is 0.1 to 100 ppm, and an amount of Al is 10 to 10000 ppm.

4. The thermoelectric conversion material according to any of claims 1 to 3, containing As and Bi.

5. The thermoelectric conversion material according to any of claims 1 to 4, wherein a density of the sintered body is 70% or more of a theoretical value, and a non-dimensionalized performance factor ZT at an operating temperature of 300 to 600°C is 0.5 or more.

6. The thermoelectric conversion material according to any of claims 1 to 5, wherein particles of the magnesium silicide constituting the sintered body are in contact with each other, and at least part of the particles are in a fusion bonded state.

7. A thermoelectric conversion element comprising: two electrodes; and a thermoelectric conversion member disposed between the two electrodes and composed of, as a constituent component, the thermoelectric conversion material according to any of claims 1 to 6.

8. A method for manufacturing a thermoelectric conversion material, comprising: a mixing step of mixing silicon and magnesium to obtain a mixture; a synthesizing step of synthesizing magnesium silicide by melting the obtained mixture in a sealed condition under a reducing atmosphere; and a sintering step of pressurizing-compression-sintering the synthesized magnesium silicide, these steps being sequentially performed, wherein high-purity silicon and/or purified and refined silicon is used as the silicon, and wherein, in the mixing step, the synthesizing step, and/or the firing step, at least one element selected from As, Sb, P, Al, and B is added as a dopant if necessary.

9. The method for manufacturing a thermoelectric conversion material according to claim 8, further comprising, after the synthesizing step and before the sintering step, a pulverizing step of pulverizing the magnesium silicide.

10. The method for manufacturing a thermoelectric conversion material according to claim 8, further comprising a silicon oxide eliminating step, and wherein the purified and refined silicon is obtained by subjecting silicon sludge to the silicon oxide eliminating step.

11. The method for manufacturing a thermoelectric conversion material according to claim 10, wherein the silicon oxide eliminating step is performed at 400 to 1000°C under reduced pressure in a reducing atmosphere containing hydrogen gas and/or deuterium gas and, if necessary, an inert gas.

12. The method for manufacturing a thermoelectric conversion material according to claim 10 or 11, further comprising the dewatering step, and wherein the purified and refined silicon is obtained by performing the dewatering step before the silicon oxide eliminating step, the dewatering step being performed at 80 to 500°C in air, vacuum, or a gas atmosphere.

13. The method for manufacturing a thermoelectric conversion material according to any of claims 10 to 12, wherein, before the dewatering step in the purifying and refining step, the silicon sludge is subjected to filtration and separation treatment so as to have a silicon concentration of 90 mass % or more and a water content of 10 mass % or less.

14. The method for manufacturing a thermoelectric conversion material according to any of claims 8 to 13, wherein before the synthesizing step the mixture obtained in the mixing step is dewatered at 80 to 500°C under reduced pressure.

15. The method for manufacturing a thermoelectric conversion material according to any of claims 8 to 14, wherein, in the synthesizing step, the magnesium silicide is generated by heat-treating and melting the magnesium and the silicon at a temperature between the melting point of magnesium and the melting point of silicon under reduced pressure in a reducing atmosphere containing hydrogen gas and, if necessary, an inert gas.

16. The method for manufacturing a thermoelectric conversion material according to any of claims 8 to 15, wherein in the synthesizing step the mixture obtained in the mixing step is melted in a crucible made of a material containing Al.

17. The method for manufacturing a thermoelectric conversion material according to any of claims 8 to 16, wherein in the sintering step the $Mg_2Si$ powder obtained by pulverization is sintered at a sintering temperature of 600 to 1000°C and a sintering pressure of 5 to 60 MPa under reduced pressure using a pressurizing compression sintering method.

18. The method of for manufacturing a thermoelectric conversion material according to any of claims 8 to 17, wherein purified and refined silicon or high-purity silicon is used as the silicon, and the silicon and the magnesium are mixed in an atomic ratio of Mg : Si being 2.2 : 0.8 to 1.8 : 1.2.

19. The method for manufacturing a thermoelectric conversion material according to any of claims 8 to 17, wherein a mixture of purified and refined silicon and high-purity silicon is used as the silicon, wherein the purified and refined silicon is mixed with the high-purity silicon such that a ratio of the high-purity silicon to the purified and refined silicon is 0 to 50 mass % / 100 to 0 mass %, and wherein the magnesium is mixed with the total amount silicon of the purified and refined silicon and the high-purity silicon in an atomic ratio of Mg : Si being 2.2 : 0.8 to 1.8: 1.2.

20. The method for manufacturing a thermoelectric conversion material according to any of claims 8 to 19, wherein the silicon sludge is a waste product produced during grinding and/orpolishing of a silicon ingot and/or a silicon wafer.

21. The method for manufacturing a thermoelectric conversion material according to any of claims 8 to 20, wherein p-type silicon sludge containing B is used as the silicon sludge.

**22.** The method for manufacturing a thermoelectric conversion material according to any of claims 8 to 20, wherein n-type silicon sludge containing at least one of As, Sb, and P is used as the silicon sludge.

**23.** Purified and refined silicon obtained by subjecting silicon sludge at least to a silicon oxide eliminating step, the purified and refined silicon containing no silicon oxide and being packed in a container and held in an inert gas atmosphere or in a vacuum.

FIG. 1 (a)

FIG. 1 (b)

FIG. 2

# FIG. 3

Heating

Th ——————————————————— 5

| 102 | P-type thermoelectric conversion member | N-type thermoelectric conversion member | 101 |

6 ——————————— 6

Tc

Heat radiation

Load

( + )   ( − )

3

FIG. 4

Heat absorption

102 — P-type thermoelectric conversion member

N-type thermoelectric conversion member — 101

5 — Tc

6 —

6 — Th

Heat radiation

Power source

( − )     ( + )

4

# FIG. 5

Heating

Thermoelectric conversion member

5 Th

103

6 Tc

Heat radiation

( + )    Load    ( − )

3

## FIG. 6

FIG. 7

Heating

103

Th

5

Tc

6

Heat radiation

Load

( + )

( − )

3

FIG. 8

## INTERNATIONAL SEARCH REPORT

| International application No. |
|---|
| PCT/JP2007/075052 |

A.  CLASSIFICATION OF SUBJECT MATTER
*H01L35/20*(2006.01)i, *C02F11/00*(2006.01)i, *C02F11/12*(2006.01)i, *C04B35/00*(2006.01)i, *C04B35/58*(2006.01)i, *H01L35/34*(2006.01)i

According to International Patent Classification (IPC) or to both national classification and IPC

B.  FIELDS SEARCHED

Minimum documentation searched (classification system followed by classification symbols)
H01L35/20, C02F11/00, C02F11/12, C04B35/00, C04B35/58, H01L35/34

Documentation searched other than minimum documentation to the extent that such documents are included in the fields searched
Jitsuyo Shinan Koho        1922-1996    Jitsuyo Shinan Toroku Koho    1996-2008
Kokai Jitsuyo Shinan Koho  1971-2008    Toroku Jitsuyo Shinan Koho    1994-2008

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2006-128235 A  (National Institute of Advanced Industrial Science and Technology), 18 May, 2006 (18.05.06), Claims 1 to 3 (Family: none) | 1<br>1-2 |
| X<br>Y | JP 2002-368291 A  (Tokyo Yogyo Kabushiki Kaisha), 20 December, 2002 (20.12.02), Par. Nos. [0010] to [0011] (Family: none) | 1<br>1-2 |
| Y | JP 2000-054009 A  (Yazaki Corp.), 22 February, 2000 (22.02.00), Claims 1 to 4 (Family: none) | 1 |

☒  Further documents are listed in the continuation of Box C.        ☐  See patent family annex.

| * | Special categories of cited documents: |
|---|---|
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 17 March, 2008 (17.03.08) | 25 March, 2008 (25.03.08) |

| Name and mailing address of the ISA/<br>Japanese Patent Office | Authorized officer |
|---|---|
| Facsimile No. | Telephone No. |

Form PCT/ISA/210 (second sheet) (April 2007)

**INTERNATIONAL SEARCH REPORT**

| | International application No. |
|---|---|
| | PCT/JP2007/075052 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 9-165212 A  (Kawasaki Steel Corp.),<br>24 June, 1997 (24.06.97),<br>Claims 1 to 8<br>(Family: none) | 2 |
| Y | JP 2006-231245 A  (Uchida Kogyo Kabushiki Kaisha),<br>07 September, 2006 (07.09.06),<br>Par. No. [0002]<br>(Family: none) | 2 |

Form PCT/ISA/210 (continuation of second sheet) (April 2007)

EP 2 400 572 A1

**INTERNATIONAL SEARCH REPORT**

International application No.

PCT/JP2007/075052

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
See extra sheet.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
Claims 1 and 2

**Remark on Protest**      the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

| INTERNATIONAL SEARCH REPORT | International application No. |
|---|---|
| | PCT/JP2007/075052 |

Continuation of Box No.III of continuation of first sheet(2)

The requirement of unity of invention in an international application (Rule 13.1 of the Regulations under the PCT), as provided for in Rule 13.2 of the Regulations under the PCT, is satisfied only when there is a technical relationship, among the group of inventions described in the claims, which involves one or more, identical or corresponding special technical features (technical features clearly showing a contribution made by the inventions as a whole to the prior art).

In this application, a technical feature common among the subject matters of claims 1-2, 3, 4, 5, 6, 7, and 8-22 is the matter of claim 1.

On the other hand, JP 2006-128235 A (National Institute of Advanced Industrial Science and Technology), 18 May, 2006, claims 1-3 and JP 2002-368291 A (Tokyo Yogyo Kabushiki Kaisha), 20 December, 2002, [0010]-[0011] disclose the subject matter of claim 1 in this international application.

Therefore, that common technical feature is considered to have already been a known technical feature at the time of the filing of this international application. It cannot hence be regarded as a technique contributing to the prior art. Consequently, that feature is not considered to be a special technical feature in the meaning defined by the rule.

In addition, any other matters in the subject matters are not considered to be identical or corresponding special technical features.

Likewise, it is not considered that the subject matter of claim 1 and the subject matter of claim 23 have identical or corresponding special technical features.

For these reasons, it cannot be said that there are identical or corresponding special technical features in the subject matters in this application. The claims of this international application do not comply with the requirement of unity of invention as provided for in Rule 13.1 of the Regulations under the PCT.

Form PCT/ISA/210 (extra sheet) (April 2007)

**EP 2 400 572 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3291487 B
- JP 2003200005 A
- JP 2003103267 A
- JP 2004122093 A
- JP H11274578 B
- JP 2002285274 A

**Non-patent literature cited in the description**

- Semiconducting Properties of Mg2Si Single Crystals. *Physical Review,* 15 March 1958, vol. 109 (6), 1909-1915
- Seebeck Effect In Mg2Si Single Crystals. J. Phys. Chem. Solids. Pergamon Press, 1962, vol. 23, 601-610
- Bulk crystal growth of Mg2Si by the vertical Bridgman method. *Science Direct, Thin Solid Films,* 2004, vol. 461, 86-89